Europäisches Patentamt

European Patent Office

Office européen des brevets

(19)

(11) **EP 0 797 301 B1**

(12) **EUROPÄISCHE PATENTSCHRIFT**

(45) Veröffentlichungstag und Bekanntmachung des Hinweises auf die Patenterteilung:
**22.08.2001 Patentblatt 2001/34**

(51) Int Cl.[7]: **H03K 17/567**, H03K 17/16,
H03K 17/0812

(21) Anmeldenummer: **97810113.7**

(22) Anmeldetag: **03.03.1997**

(54) **Verfahren zur Einschaltregelung eines IGBTs und Vorrichtung zur Durchführung des Verfahrens**

Method for controlling the turn-on of an IGBT and device for carrying out the method

Procédé pour le réglage de la mise en conduction d'un transistor bipolaire à grille isolée et dispositif pour sa mise en oeuvre

(84) Benannte Vertragsstaaten:
**AT CH DE ES FI FR GB IT LI SE**

(30) Priorität: **20.03.1996 DE 19610895**

(43) Veröffentlichungstag der Anmeldung:
**24.09.1997 Patentblatt 1997/39**

(73) Patentinhaber: **ABB RESEARCH LTD.**
**8050 Zürich (CH)**

(72) Erfinder: **Pieder, Jörg**
**7013 Domat/Ems (CH)**

(74) Vertreter: **ABB Patent Attorneys**
**c/o ABB Business Services Ltd,**
**Intellectual Property (SLE-I),**
**Haselstrasse 16/699**
**5401 Baden (CH)**

(56) Entgegenhaltungen:
**EP-A- 0 690 572            DE-A- 3 723 786**
**JP-A- 7 226 663            US-A- 5 383 082**

- **PATENT ABSTRACTS OF JAPAN vol. 018, no. 148 (E-1522), 11. März 1994 & JP 05 327440 A (FUJI ELECTRIC CO LTD), 10. Dezember 1993**
- **HEFNER A R ET AL: "AN EXPERIMENTALLY VERIFIED IGBT MODEL IMPLEMENTED IN THE SABER CIRCUIT SIMULATOR" IEEE TRANSACTIONS ON POWER ELECTRONICS, Bd. 9, Nr. 5, September 1994, Seiten 532-542, XP000670517**
- **ECKEL H -G ET AL: "OPTIMIZATION OF THE SHORT-CIRCUIT BEHAVIOUR OF NPT-IGBT BY THE GATEDRIVE" EPE '95: 6TH. EUROPEAN CONFERENCE ON POWER ELECTRONICS AND APPLICATIONS, SEVILLA, SEPT. 19 - 21, 1995, Bd. 2, Nr. CONF. 6, 19. September 1995, Seiten 2.213-2.218, XP000537747 EUROPEAN POWER ELECTRONICS AND DRIVES ASSOCIATION**
- **GEDIGA S ET AL: "HIGH POWER IGBT CONVERTERS WITH NEW GATE DRIVE AND PROTECTION CIRCUIT" EPE '95: 6TH. EUROPEAN CONFERENCE ON POWER ELECTRONICS AND APPLICATIONS, SEVILLA, SEPT. 19 - 21, 1995, Bd. & 1, Nr. CONF. 6, 19. September 1995, Seiten 1.066-1.070, XP000537497 EUROPEAN POWER ELECTRONICS AND DRIVES ASSOCIATION**

**Beschreibung**

**Technisches Gebiet**

Die Erfindung bezieht sich auf das Gebiet der Leistungselektronik. Sie geht aus von einem Verfahren zur Einschaltregelung eines Bipolartransistors mit isoliert angeordneter Gateelektrode (IGBT) nach dem Oberbegriff des ersten Anspruchs. Im weiteren betrifft sie eine Vorrichtung zur Durchführung des Verfahrens.

**Stand der Technik**

Ein solches Verfahren bzw. eine entsprechende Vorrichtung wird beispielsweise in den Artikeln "Optimization of the Short-Circuit Behaviour of NPT-IGBT by the Gate Drive", EPE '95, Sevilla, Seiten 2.213-2.218, von H.-G. Eckel und L. Sack und "High Power IGBT Converters with new Gate Drive and Protection Circuit", EPE'95, Seiten 1.006-1.070, von S. Gediga, R. Marquardt, R. Sommer beschrieben.

Eine solche Vorrichtung ist Teil eines sogenannten Gatedrives. Diese dient der Ansteuerung des IGBTs, d.h. sie liefert die benötigten Ein- und Ausschaltpulse. Eine weitere wichtige Aufgabe des Gatedrives ist es, den IGBT in allen Betriebszuständen vor zu hohen Spannungen oder Strömen zu schützen. Dazu gehört insbesondere auch eine Begrenzung der Strom- und Spannungssteilheiten. Eine Beschränkung der Stromanstiegsgeschwindigkeit dient auch dem Schutz der am Schaltvorgang mitbeteiligten Diode. Bekannte Gatedrives wie z.B. diejenige aus dem erwähnten Artikel "Optimization of the Short-Circuit ..." bestehen im wesentlichen aus einer Spannungsquelle, die zwei Spannungen, eine für den eingeschalteten Zustand (typ. 15V) und eine für den ausgeschalteten Zustand (typ. - 15V) liefern kann. Diese binäre Spannungsquelle ist mit dem IGBT-Gate über einen Widerstand, der den Strom ins Gate begrenzt, verbunden. Für das Einschalten des IGBT wird die Quelle von der negativen direkt auf die positive Spannung umgeschaltet. Das Gate, welches als Kapazität betrachtet werden kann, wird geladen. Je weiter die Gatespannung angestiegen ist, um so kleiner wird der Gatestrom und um so langsamer steigt die Gatespannung. Um die Anstiegsgeschwindigkeit des Anoden-Kathodenstroms zu begrenzen, wird versucht, diese lastseitig zu erfassen, meist durch Messung des Spannungsabfalls über einer ohnehin vorhandenen, parasitären Induktivität. Mit einer geeigneten Rückführung wird in der Regel durch Öffnen eines Parallelpfads Strom am Gate vorbeigezogen, was den Ladevorgang verlangsamt. Nachteil dieser Lösung ist, dass ein zusätzlicher, lastseitiger Sensor notwendig ist. Zudem ist das gewonnene Signal klein und somit störanfällig. Das Laden der Oxydkapazität des IGBT beim Einschalten erfolgt meist sehr langsam, da hier die stromtreibende Differenz über dem Gatewiderstand klein ist. Die damit zusammenhängende Geschwindigkeit des lastseitigen Spannungsabbaus ist schlecht zu kontrollieren und meist zu langsam.

Im zweiten Artikel "High Power IGBT Converters ..." wird versucht, diesen zusätzlichen Sensor durch Einprägung einer vorgegebenen Spannungszeitfunktion beim Einschalten zu vermeiden. Die Spannungsquelle ist aber nach wie vor über einen relativ grossen Widerstand mit dem IGBT-Gate verbunden. Dadurch hinkt die tatsächliche Spannung am Gate der eingeprägten Spannungszeitfunktion wesentlich nach.

Weiterhin ist aus der JP 07226663 eine Treiberschaltung für einen Transistor, insbesondere einen IGBT, bekannt, die eine spannungsgesteuerte Stromquelle in Form eines Widerstandes und einer Bypassschaltung aufweist, wobei die Stromquelle zwischen der Gateelektrode und der Kathodenelektrode des IGBTs angeordnet ist. Unterhalb der Threshold-Spannung des IGBT ist die Bypassschaltung aktiv, so dass der Widerstand überbrückt wird. Dadurch wird erreicht dass die Anstiegszeit der Gatespannung verkleinert wird, um die Einschaltzeit des IGBT wirksam zu verkürzen. Oberhalb der Threshold-Spannung ist die Bypassschaltung nicht aktiv.

**Darstellung der Erfindung**

Aufgabe der vorliegenden Erfindung ist es deshalb, ein Verfahren bzw. eine Vorrichtung zur Durchführung des Verfahrens anzugeben, die einen möglichst einfachen Aufbau aufweisen und den IGBT beim Einschalten in allen Betriebszuständen in der SOA (Safe Operating Area) halten können, ohne dass lastseitige Begrenzungs- oder Überwachungseinrichtungen notwendig sind. Ausserdem soll das Verfahren eine Regelung der Stromanstiegsgeschwindigkeit beim Einschalten (di/dt) erlauben und zwar ohne lastseitiges Erfassen des Stromes.

Diese Aufgabe wird bei einem Verfahren der eingangs genannten Art durch die Merkmale des ersten Anspruchs gelöst.

Kern der Erfindung ist es also, dass im Gegensatz zum Stand der Technik nicht die Gatespannung als Steuergrösse verwendet wird, sondern der Gatestrom. Dieser beaufschlagt die Gateelektrode nach Massgabe eines Soll-Ist-Vergleichs einer an der Gateelektrode anliegenden Spannungs-Istwertes und eines entsprechenden Sollwertes. Die Regelung führt den Laststrom während des Schaltvorgangs auf einer vorgegebenen Trajektorie. Trotzdem ist lastseitig keine Stromerfassung notwendig. Statt dessen macht man sich zu Nutze, dass während des Einschaltens der MOSFET im IGBT dessen Verhalten dominiert. Es kann gezeigt werden (siehe unten), dass zwischen der Gatespannung und dem Laststrom ein quadratischer Zusammenhang besteht, sobald die Gatespannung grösser als die Thresholdspannung ist. Dies gilt, bis der volle Laststrom fliesst. Eine Regelung der Gatespannung auf eine bestimmte Trajektorie vom ausgeschalteten in den eingeschalteten Zustand lässt den Laststrom quadratisch proportional dazu ansteigen. Umgekehrt kann der Gatespannungsverlauf zu einem gewünschten Laststromverlauf leicht berechnet werden.

Das Gate des IGBT ist eine elektrische Kapazität, an welcher nun die Spannung geregelt werden muss. Steuergrösse kann nur der Strom in das Gate sein. Als Regelung genügt ein einfacher Proportionalregler. Der Gatestrom ist dann proportional zur Differenz zwischen der gewünschten und der tatsächlichen Gatespannung. In der schaltungstechnischen Umsetzung wird ein Funktionsgenerator über einen Vergleicher und einen Proportionalregler mit einer spannungsgesteuerten Stromquelle verbunden. Der Funktionsgenerator wird entlang einer gewählten Kurve gesteuert. Die so angesteuerte Stromquelle prägt den gewünschten Steuerstrom in das Gate des IGBTs ein.

Die Erfindung bringt neben der völligen Beherrschung des Stromanstiegs beim Einschalten auch Vorteile für die übrigen Betriebszustände. Das Laden des Gates bis auf die Thresholdspannung kann sehr schnell erfolgen, denn dies hat keinen Einfluss auf die Lastseite. Nachdem der IGBT den vollen Laststrom übernommen hat, kann durch Begrenzen des Gatestroms auch die Geschwindigkeit der lastseitigen Spannungsänderung am IGBT (Einschalt-du/dt) begrenzt werden, weil mit kleinerem Gatestrom die Oxydkapazität langsamer geladen wird. Schliesslich lässt sich durch Vorgabe geeigneter Gatespannungs-Sollverläufe auch der Spannungsanstieg beim Ausschalten des IGBT beeinflussen.

Weitere Ausführungsbeispiele ergeben sich aus den entsprechenden abhängigen Ansprüchen.

## Kurze Beschreibung der Zeichnungen

Nachfolgend wird die Erfindung anhand von Ausführungsbeispielen im Zusammenhang mit den Zeichnungen näher erläutert.

Es zeigen:

Fig. 1      Ein Ersatzschaltbild einer Vorrichtung, mit der das erfindungsgemässe Verfahren durchgeführt werden kann;

Fig. 2      Ein Ersatzschaltbild eines IGBT-Modells;

Fig. 3-5      Verschiedene von Spannungszeit-Funktionen.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

## Wege zur Ausführung der Erfindung

Die Erfindung basiert auf einer nicht trivialen, eingehenden Analyse eines IGBT-Modells. Ein IGBT-Modell ist beispielsweise im Artikel "An Experimentally Verfied IGBT Model Implemented in the Saber Circuit Simulator", IEEE Trans. on Power Electronics, Vol. 9, Sept. 1994, von A.R. Hefner und D.M. Diebolt beschrieben. In dieser Schrift sind ausserdem alle im folgenden verwendeten Gleichungen zu finden.

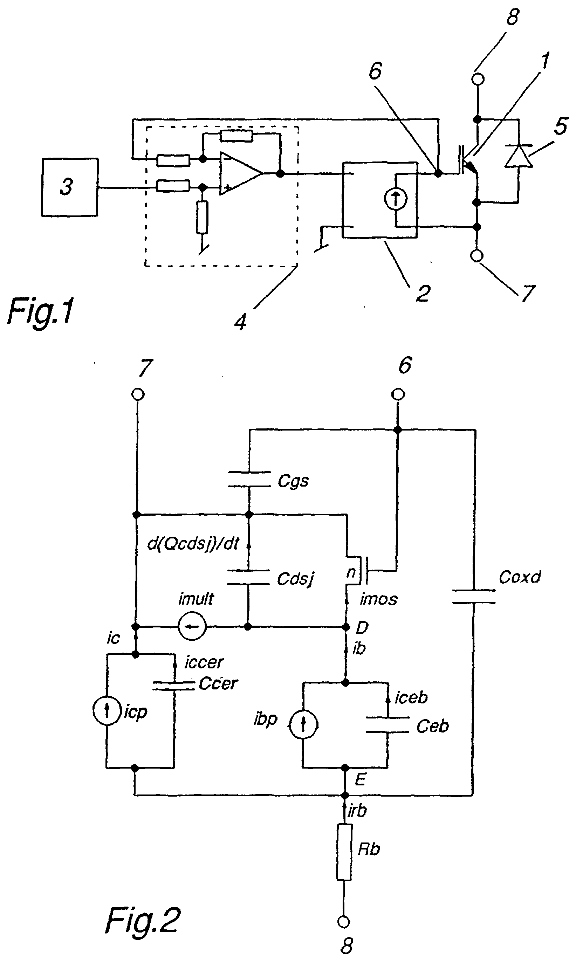

In Figur 2 wird versucht, die Modellgleichungen durch ein elektrisches Netzwerk zu visualisieren. Die Bezeichnungen der Elemente und Ströme entspricht im wesentlichen derjenigen der vorstehend genannten Schrift. Insbesondere die eingeprägten Ströme sind aber höchst nichtlinear. Das Modell besitzt sechs elektrische Knoten, in denen die Kirchhoffschen Gleichungen erfüllt sein müssen. Der Laststrom setzt sich aus den Teilströmen zusammen, welche vom bipolaren Emitter direkt zur Kathode fliessen, und aus jenen, die vom bipolaren Emitter über das MOS-Drain (= bipolare Basis) zur Kathode fliessen. Erstere bezeichnet man in ihrer Summe auch als Bipolar-Strom, letztere als MOS-Strom.

Zuerst wird der MOS-Strom betrachtet. Er setzt sich gemäss Figur 2 aus zwei Teilen zusammen: dem sog. Emitter-Basis-DC-Strom $i_{bp}$ und einem Verschiebungsstrom durch Basisladungsänderungen $i_{ceb}$. Ihre Summe wird als $i_b$ bezeichnet. Der Strom $i_b$ muss wegen der Knotenregel gleich dem Strom vom Drain D zur Kathode 7 sein. Dieser setzt sich auch aus drei Teilen zusammen: Dem eigentlichen Strom im MOS-Kanal $i_{mos}$, dem Strom $i_{mult}$, welcher Ladungsträgermultiplikation durch plötzliche Ionisation im hohen elektrischen Feld reflektiert, und aus dem Verschiebungsstrom in der Drain-Source-Kapazität $d(Q_{cdsj})/dt$. Der Strom $i_{mos}$ ist klar bestimmt. Der Strom $i_b$ ist somit praktische gleich $i_{mos}$.

Als zweites wird der Bipolar-Strom betrachtet: Er ist die Summe des Emitter-Collector-DC-Stroms $i_{cp}$ und des Redistributions-Stroms $i_{ccer}$. Der Strom $i_{ccer}$ kann beim Einschalten vernachlässigt werden. Der Strom $i_{cp}$ muss nochmals einzeln analysiert werden.

$$i_{cp} = \left(\frac{1}{1+b}\right) i_{rb} + \left(\frac{b}{1+b}\right) \frac{4D_p}{W^2} Q_{ceb} \qquad (1)$$

mit

b: ambipolares Beweglichkeitsverhältnis
Dp: Löcher Diffusionskonstante
W=W(t): Breite der neutralen Basis
$Q_{ceb}=Q_{ceb}(t)$: Emitter-Basis Ladung

$i_{cp}$ setzt sich gemäss Gl. (1) zusammen aus einem Anteil, der die Kopplung zwischen Löcher- und Elektronenstrom reflektiert (linker Summand) und einem ladungsbestimmten Anteil (rechter Summand). Der Anteil des rechten Summanden beträgt etwa 10% am gesamten Laststrom.

Aus diesen Ausführungen folgt, dass für den Reglerentwurf der Laststrom beim Einschalten als Summe des Stroms im MOS-Kanal $i_{mos}$ und des durch die Kopplung des Löcher- und Elektronentransports bestimmten Anteils des Bipolar-Stroms (linker Summand in (1)) bestimmt ist. Alle anderen Einflüsse werden als Störgrössen aufgefasst.

Als nächstes wird der Zusammenhang zwischen dem MOS-Strom und dem betrachteten Bipolar-Strom *icp** untersucht. Aus (1) wird unter Vernachlässigung des rechten Summanden (2).

$$i_{cp}{}^* = \left(\frac{1}{1+b}\right) i_{rb} \qquad (2)$$

Der MOS-Strom *imos* und der Bipolar-Strom *icp** summieren sich im Emitter-Knoten E (vgl. Figur 2) zu *irb* (Gleichung (3)).

$$i_{rb} = i_{cp}{}^* + i_{mos} \qquad (3)$$

Auflösen von (2) nach $i_{rb}$ und Einsetzen in (2) mit anschliessendem Auflösen nach $i_{mos}$ ergibt Gleichung (4).

$$i_{mos} = \frac{1}{b} \cdot i_{cp} \qquad (4)$$

Der Gesamtstrom hängt nach Gleichung (5) mit dem MOS-Strom zusammen. Die beiden Ströme sind demnach linear proportional zueinander.

$$i_{rb} = \frac{1}{b} i_{mos} + i_{mos} = \left(\frac{1+b}{b}\right) i_{mos} \qquad (5)$$

Der IGBT wird vom Gate her kontrolliert. Im folgenden wird daher nach einem für die Regelung verwendbaren Zusammenhang zwischen den Gategrössen und dem Laststrom gesucht. Der "innere" MOSFET des IGBT ist während der ansteigenden Flanke des Laststroms in der Sättigung. Es gilt der bekannte quadratische Zusammenhang nach Gleichung (6) zwischen Gatespannung und MOS-Kanalstrom. Man beachte, dass die Gatespannung in dieser Phase bereits grösser als die Threshold-Spannung ist.

$$i_{mos} = K_p((v_{gs}-v_t))^2 \frac{1}{2} \qquad (6)$$

mit

$K_p$:MOS-Steilheit im Sättigungsbereich

$v_t$: Threshold-Spannung des MOSFET

$v_{gs}$: Gatespannung

Einsetzen von (6) in (5) ergibt einen einfachen, quadratischen Zusammenhang (7) zwischen dem Laststrom und der Gatespannung, welcher während der Einschaltphase gilt.

$$i_{rb} = \left(\frac{1+b}{b}\right) K_p \left(v_{gs} - v_t\right)^2 \frac{1}{2} \qquad (7)$$

Folgerungen für eine Regelung:

Durch Kontrolle der Gatespannung kann der Laststrom während des Anstiegs geregelt werden. Eine Messung der Steilheit über der Seriestreuinduktivität im Lastkreis entfällt. Das regelungstechnische Problem muss nun anders gestellt werden: Als Steuergrösse dient der Strom ins Gate des IGBT, während die Gatespannung, die ja den IGBT kontrolliert, die zu regelnde Grösse ist. Es sei darauf hingewiesen, dass es sich bei der zu lösenden Regelungsaufgabe um eine sogenannte Trackingaufgabe handelt, im Gegensatz zu einer Regelung auf einen Arbeitspunkt. Es muss nun eine geeignete Trajektorie gefunden werden, auf welcher der Regler zu führen hat. Dies stellt für den Schaltungsentwurf aber auch einen zusätzlichen Freiheitsgrad dar.

Mit dem Gatestrom als Steuergrösse muss also die Gatespannung geregelt werden. Diese Regelstrecke stellt einen Integrator, gebildet durch die Gate-Source-Kapazität des MOSFET und durch die Oxydkapazität, dar. Die Oxydkapazität hat jedoch nur am Schluss des Einschaltvorgangs einen Einfluss. Als Regler bietet sich ein Proportionalregler an. Das resultierende Closed-Loop-System ist erster Ordnung, so dass auch keine Schwingungen möglich sind. Die Verstärkung des Proportionalreglers wird durch den maximal lieferbaren Gatestrom begrenzt.

Figur 1 zeigt ein Ausführungsbeispiel einer solchen Regelvorrichtung. Mit 1 ist der IGBT bezeichnet, zu dem eine Freilaufdiode 5 antiparallel liegt. Diese beiden Elemente können Teil einer leistungselektronischen Schaltung wie z.B. eines mehrphasigen Umrichters in Brückenschaltung sein. Als Last dieser Schaltung kommt beispielsweise ein stark induktiver Antriebsmotor in Frage.

Die Steuerelektrode bzw. Gateelektrode 6 des IGBT 1 wird von einer spannungsgesteuerten Stromquelle 2 gespeist. Diese ist zwischen der Gateelektrode 6 und der Kathodenelektrode 7 des IGBT 1 angeordnet. Die steuernde Spannung wird durch die Ausgangsspannung eines Differenzverstärkers 4 gebildet. Der Differenzverstärker 4 bildet einen Vergleicher und einen Proportionalregler. Eine Gatespannung wird an der Gateelektrode 6 des IGBT 1 gemessen und mit einer von einem Funktionsgenerator 3 vorgegebenen Spannungstrajektorie verglichen. Das Ergebnis dieses Soll-Istwert-Vergleichs wird im Proportionalregler verstärkt und dient der Ansteuerung der Stromquelle 2.

Im folgenden werden verschiedene Varianten geeigneter Trajektorien vorgestellt: Es soll ein Stromanstieg von ca. 0.8 kA/µs erreicht werden. Der Anstieg der Spannung von -15 V (IGBT gesperrt) bis zur Threshold-Spannung von z.B. 7 V kann frei gewählt werden, da er keinen Einfluss auf die Lastseite hat. Begrenzend wirkt hier allenfalls der von der Stromquelle maximal lieferbare Gatestrom. Der Spannungsanstieg in diesem Bereich kann somit linear in z. B. 3µs von -15 V auf 7 V ansteigen. Die Art und Weise, wird die Gatespannung von der Thresholdspannung weiter ansteigt bis zu der je nach Typ und Anwendung bei 10V bis 11V liegenden Spannung, bei welcher der IGBT den vollen Strom übernommen hat, bestimmt das Verhalten des Stromes auf der Lastseite. Am einfachsten ist es, die Gatespannung linear ansteigen zu lassen. Der Laststrom steigt dann quadratisch. Um ungefähr 0.8kA/µs Anstiegsgeschwindigkeit zu erreichen, muss die Gatespannung für einen 2.5kV IGBT in 3µs von 6.5V auf 10.5V ansteigen. Der weitere Anstieg bis zur Beharrungsspannung im leitenden Zustand bei 15V beeinflusst wesentlich die Spannungsabfallgeschwindigkeit des IGBT. Hier kann auch eine Gerade verwendet werden, die um so steiler gewählt wird, je steiler die Spannung über dem IGBT abfallen darf. Typisch ist sie gleich steil oder leicht flacher als im mittleren Abschnitt, da insbesondere auch die Gatespannung beim Übergang vom letzten zu diesem Abschnitt laststromabhängig ist.

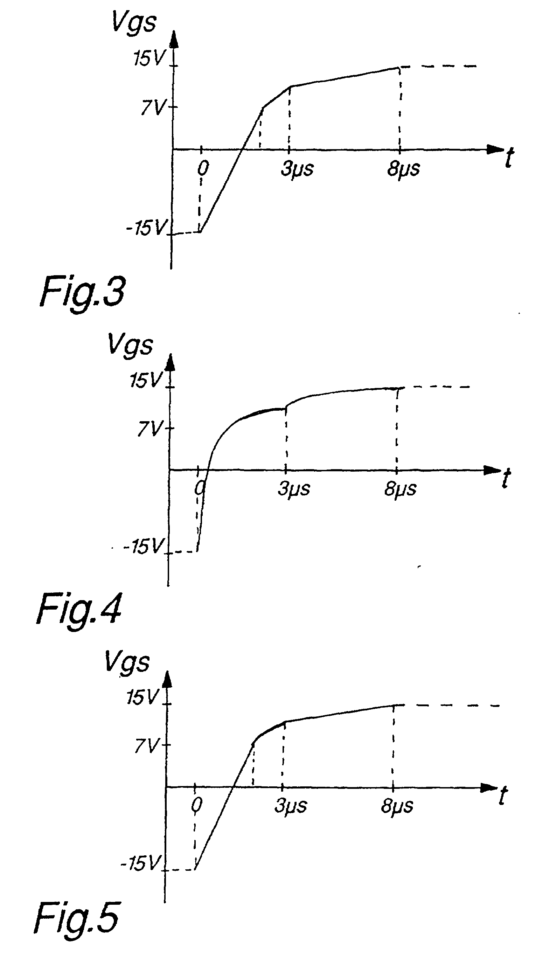

Die Spannungstrajektorie bildet nach dem oben erläuterten Beispiel also drei Geraden (Figur 3). Die erste Gerade steigt von -15V bis zur Threshold-Spannung. Die zweite beginnt bei der Thresholdspannung und steigt bis zur einer Gatespannung, bei der der IGBT vollständig durchgeschaltet ist. Die Dritte Gerade steigt anschliessend noch bis 15V. Eine weitere Variante ist das Zusammenfassen der ersten beiden Abschnitte in einen Anstieg der Form

$$\left(1 - e^{-\frac{t}{\tau}}\right).$$

Diese Kurve führt das Gate schnell auf die Threshold-Spannung. Ausserdem führt sie den Laststrom so, dass der Anstieg im unteren Bereich steiler ist als im oberen. Dadurch ist eine Minimierung der Verlustleistung bei gleichzeitigem Schutz der Diode möglich. Der dritte Abschnitt wird dann der Einfachheit halber ebenfalls eine

$$\left(1 - e^{-\frac{t}{\tau}}\right)\text{-Form}$$

aufweisen (Figur 4). Als weitere Variante ist im mittleren Abschnitt auch ein Verlauf in Form einer Wurzelfunktion denkbar (Figur 5). Diese Variante zeichnet sich insbesondere durch eine Minimierung der zur Fläche unter der Stromkurve proportionalen Verlustleistung aus.

Der Funktionsgenerator zur Erzeugung der oben erwähnten Spannungs-Trajektorien kann digital oder analog aufgebaut sein. Bei einem analogen Aufbau bietet sich insbesondere die

$$\left(1 - e^{-\frac{t}{\tau}}\right)\text{-Form}$$

an, da diese mittels Aufladen von Kondensatoren auf einfache Weise realisiert werden kann. Bei einem digitalen Aufbau kann auch die Wurzelform realisiert werden, z.B. durch eine abgelegte Funktionstabelle in Form einer Look-Up-Table.

Insgesamt steht also mit der Erfindung ein Verfahren zur Einschaltregelung eines IGBT und eine entsprechende Vorrichtung zur Verfügung, die ohne lastseitige Strom- oder Spannungsmessung eine Stromanstiegsbegrenzung auf schaltungstechnisch einfache Weise erreicht.

Bezugszeichenliste

1   IGBT
2   spannungsgesteuerte Stromquelle
3   Funktionsgenerator
4   Differenzverstärker
5   Freilaufdiode
6   Gateelektrode
7   Kathodenelektrode
8   Anodenelektrode

**Patentansprüche**

1. Verfahren zur Einschaltregelung eines Bipolartransistors mit isoliert angeordneter Gateelektrode-IGBT-; bei dem die Gateelektrode mit einem Steuerstrom beaufschlagt wird, der nach Massgabe eines Soll-Ist-Vergleichs eines an der Gateelektrode anliegenden Spannungs-Istwertes und eines vorgegebenen Sollwertes gebildet wird, wobei als Sollwert eine Spannungsanstiegsfunktion vorgegeben wird, dadurch gekennzeichnet,
dass die Spannungsanstiegsfunktion im wesentlichen drei Teile umfasst, wobei die Spannung im ersten Teil bis zur Threshold-Spannung des IGBT ansteigt, im zweiten Teil von der Threshold-Spannung bis zu einem Wert der Gatespannung, bei dem der IGBT den vollen Laststrom übernommen hat, und in einem dritten Teil von diesem Wert bis zu einem Maximalwert der Gatespannung.

2. Verfahren nach Anspruch 1, dadurch gekennzeichnet, dass die drei Teile einen rampenförmigen Anstieg aufweisen, wobei die Steigung des ersten Teils grösser ist als diejenige der beiden anderen.

3. Verfahren nach Anspruch 1, dadurch gekennzeichnet, dass die beiden erste Teile durch einen gemeinsamen Anstieg in der Form einer

$$\left(1-e^{-\frac{t}{\tau}}\right)\text{-Funktion}$$

realisiert werden, und dass der dritte Teil ebenfalls die Form einer

$$\left(1-e^{-\frac{t}{\tau}}\right)\text{-Funktion}$$

aufweist, wobei die Steigung des ersten Teils grösser ist als diejenige des zweiten Teils.

**4.** Verfahren nach Anspruch 1, dadurch gekennzeichnet, dass der erste und der dritte Teil einen Anstieg in der Form einer Gerade aufweisen, während der zweite, mittlere Teil die Form einer Quadaratwurzelfunktion aufweist.

**5.** Vorrichtung zur Durchführung des Verfahrens nach Anspruch 1 mit einer spannungsgesteuerten Stromquelle (2), die zwischen der Gateelektrode (6) und der Kathodenelektrode (7) des IGBTs angeordnet ist, dadurch gekennzeichnet, dass

- ein Funktionsgenerator (3) vorgesehen ist, dessen Ausgang mit einem ersten Eingang eines Vergleichers verbunden ist, wobei ein zweiter Eingang des Vergleichers mit der an der Gateeletrode (6) anliegenden Spannung belegt ist, dass
- der Ausgang des Vergleichers über einen Proportionalregler mit dem Steuereingang der spannungsgesteuerten Stromquelle (2) verbunden ist, und dass
- der Funktionsgenerator (3) eine Spannungsanstiegsfunktion erzeugt, die im wesentlichen drei Teile gemäß dem Verfahren nach Anspruch 1 umfasst.

**6.** Vorrichtung nach Anspruch 5, dadurch gekennzeichnet, dass der Vergleicher und der Proportionalregler in einem Differenzverstärker (4) integriert sind.

**7.** Vorrichtung nach Anspruch 5 oder 6, dadurch gekennzeichnet, dass die drei Teile einen rampenförmigen Anstieg aufweisen, wobei die Steigung des ersten Teils grösser ist als diejenige der beiden anderen.

**8.** Vorrichtung nach Anspruch 5 oder 6, dadurch gekennzeichnet, dass die beiden erste Teile durch einen gemeinsamen Anstieg in der Form einer

$$\left(1-e^{-\frac{t}{\tau}}\right)\text{-Funktion}$$

realisiert werden, und dass der dritte Teil ebenfalls die Form einer

$$\left(1-e^{-\frac{t}{\tau}}\right)\text{-Funktion}$$

aufweist, wobei die Steigung des ersten Teils grösser ist als diejenige des zweiten Teils.

**9.** Vorrichtung nach Anspruch 5 oder 6, dadurch gekennzeichnet, dass der erste und der dritte Teil einen Anstieg in der Form einer Gerade aufweisen, während der zweite, mittlere Teil die Form einer Quadaratwurzelfunktion aufweist.

## EP 0 797 301 B1

**Claims**

1. Method for the turn-on regulation of a bipolar transistor having an insulated gate electrode IGBT, in which the gate electrode is acted on by a control current which is formed according to a desired-actual comparison of an actual voltage value present at the gate electrode and of a predetermined desired value, wherein a voltage rise function is predetermined as the desired value, characterized in that the voltage rise function essentially comprises three parts, the voltage in the first part rising up to the threshold voltage of the IGBT, the voltage in the second part rising from the threshold voltage up to a value of the gate voltage at which the IGBT has accepted the full load current, and the voltage in a third part rising from this value up to a maximum value of the gate voltage.

2. Method according to Claim 1, characterized in that the three parts have a rise in the form of a ramp, in which case the gradient of the first part is greater than that of the two other parts.

3. Method according to Claim 1, characterized in that the first two parts are realized by a joint rise in the form of a

$$\left( 1 - e^{-\frac{t}{\tau}} \right)$$

function, and in that the third part likewise has the form of a

$$\left( 1 - e^{-\frac{t}{\tau}} \right)$$

function, in which case the gradient of the first part is greater than that of the second part.

4. Method according to Claim 1, characterized in that the first part and the third part have a rise in the form of a straight line, while the second, middle part has the form of a square root function.

5. Apparatus for carrying out the method as claimed in Claim 1, having a voltage-controlled current source (2) which is arranged between the gate electrode (6) and the cathode electrode (7) of the IGBT, characterized in that

   - a function generator (3) is provided whose output is connected to a first input of a comparator, the voltage present at the gate electrode (6) being applied to a second input of the comparator, in that
   - the output of the comparator is connected via a proportional regulator to the control input of the voltage-controlled current source (2), and in that
   - the function generator (3) generates a voltage rise function which essentially comprises three parts according to the method according to Claim 1.

6. Apparatus according to Claim 5, characterized in that the comparator and the proportional regulator are integrated in a differential amplifier (4).

7. Apparatus according to Claim 5 or 6, characterized in that the three parts have a rise in the form of a ramp, in which case the gradient of the first part is greater than that of the two other parts.

8. Apparatus according to Claim 5 or 6, characterized in that the first two parts are realized by a common rise in the form of a

$$\left( 1 - e^{-\frac{t}{\tau}} \right)$$

function, and in that the third part likewise has the form of a

$$\left(1 - e^{-\frac{t}{\tau}}\right)$$

function, in which the gradient of the first part is greater than that of the second part.

9.  Apparatus according to Claim 5 or 6, characterized in that the first part and the third part have a rise in the form of a straight line, while the second, middle part has the form of a square root function.

**Revendications**

1.  Procédé pour la régulation de la mise en circuit d'un transistor bipolaire avec électrode de gâchette isolée (IGBT) avec lequel l'électrode de gâchette est exposée à un courant de commande qui est formé d'après le résultat d'une comparaison entre la valeur réelle d'une tension présente sur l'électrode de gâchette et une valeur de consigne prédéfinie, la valeur de consigne prédéfinie étant une fonction de croissance de la tension, caractérisé en ce que la fonction de croissance de la tension comprend pour l'essentiel trois parties, la tension dans la première partie croissant jusqu'à la tension de seuil de l'IGBT, dans la deuxième partie de la tension de seuil jusqu'à une valeur de la tension de gâchette à laquelle l'IGBT a atteint le courant de charge complet, et dans une troisième partie de cette valeur jusqu'à une valeur maximale de la tension de gâchette.

2.  Procédé selon la revendication 1, caractérisé en ce que les trois parties présentent une croissance en forme de rampe, la pente de la première partie étant supérieure à celle des deux autres.

3.  Procédé selon la revendication 1, caractérisé en ce que les deux premières parties sont réalisées par une croissance commune sous la forme d'une fonction

$$\left(1 - e^{\frac{1}{t}}\right)$$

et que la troisième présente également la forme d'une fonction

$$\left(1 - e^{\frac{1}{t}}\right),$$

la pente de la première partie étant supérieure à celle de la deuxième partie.

4.  Procédé selon la revendication 1, caractérisé en ce que la première et la troisième partie présentent une croissance sous la forme d'une droite alors que la deuxième partie, centrale, présente la forme d'une fonction de racine carrée.

5.  Dispositif pour réaliser le procédé selon la revendication 1 comprenant une source de courant commandée en tension (2) qui est disposée entre l'électrode de gâchette (6) et l'électrode de cathode (7) de l'IGBT, caractérisé en ce

    -   qu'il est prévu un générateur de fonction (3) dont la sortie est reliée à une première entrée d'un comparateur, la tension présente à l'électrode de gâchette (6) étant appliquée à une deuxième entrée du comparateur,
    -   que la sortie du comparateur est reliée à l'entrée de commande de la source de courant commandée en tension (2) par le biais d'un régulateur proportionnel, et
    -   que le générateur de fonction (3) génère une fonction de croissance de la tension qui comprend essentiellement trois parties conformes au procédé selon la revendication 1.

6.  Dispositif selon la revendication 5, caractérisé en ce que le comparateur et le régulateur proportionnel sont intégrés dans un amplificateur différentiel (4).

**7.** Dispositif selon la revendication 5 ou 6, caractérisé en ce que les trois parties présentent une croissance en forme de rampe, la pente de la première partie étant supérieure à celle des deux autres.

**8.** Dispositif selon la revendication 5 ou 6, caractérisé en ce que les deux premières parties sont réalisées par une croissance commune sous la forme d'une fonction

$$\left(1 - e^{\frac{t}{t}}\right)$$

et que la troisième présente également la forme d'une fonction

$$\left(1 - e^{\frac{1}{t}}\right),$$

la pente de la première partie étant supérieure à celle de la deuxième partie.

**9.** Dispositif selon la revendication 5 ou 6, caractérisé en ce que la première et la troisième partie présentent une croissance sous la forme d'une droite alors que la deuxième partie, centrale, présente la forme d'une fonction de racine carrée.

Fig.1

Fig.2

Fig.3

Fig.4

Fig.5